(19) Europäisches Patentamt
European Patent Office
Office européen des brevets

(11) EP 1 378 757 A2

(12) **EUROPÄISCHE PATENTANMELDUNG**

(43) Veröffentlichungstag:
**07.01.2004 Patentblatt 2004/02**

(51) Int Cl.[7]: **G01R 31/00**, G01R 31/36

(21) Anmeldenummer: **03013953.9**

(22) Anmeldetag: **20.06.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **03.07.2002 DE 10229895**

(71) Anmelder: **SIEMENS AKTIENGESELLSCHAFT**
**80333 München (DE)**

(72) Erfinder:
• **Hahn, Alexander, Dr.**
**91341 Röttenbach (DE)**
• **Hain, Stefan**
**91090 Effeltrich (DE)**

(54) **Verfahren und Anordnung zur Ermittlung des Ladezustandes einer Batterie**

(57) Bei einem Verfahren und einer Anordnung zur Ermittlung des Ladezustands einer Batterie (2) durch Erfassen einer an einem in Serie zur Batterie (2) geschalteten Messwiderstand (61) auftretenden elektrischen Größe, wird der Widerstandswert ($R_{M1}$) des Messwiderstands (61) zu einem beliebig vorgebbaren Zeitpunkt gemessen. Der Messwiderstand (61) ist als Teil der elektrischen Anschlussmittel (60) zum Anschluss der Batterie (2) an einen Verbraucher (4) vorgesehen. Dadurch ist eine genaue Ermittlung des Ladezustands auch mit einem kostengünstigen und mit großen Toleranzen behafteten Messwiderstand möglich.

**FIG 3**

**Beschreibung**

Die Erfindung bezieht sich auf ein Verfahren und eine Anordnung zur Ermittlung des Ladezustands einer Batterie.

Bei batteriebetriebenen elektrischen Verbrauchern, wie z.B. Geräten oder Fahrzeugen interessiert sehr oft der aktuelle Ladezustand der Batterie, um Aussagen über die noch zu verbleibende Betriebsbereitschaftszeit des Geräts bzw. die verbleibende Restreichweite des Fahrzeugs oder über den Alterungszustand der Batterie treffen zu können. Hierzu setzt man sogenannte Batteriemonitor-Systeme (Batteriemonitore) ein. Die Kenntnis des Ladezustands einer Batterie wird dabei üblicherweise hauptsächlich ermittelt durch Messung der Entlade- bzw. Ladeströme, die der Batterie entzogen bzw. zugeführt werden.

Zur Strommessung wird oft in den Stromkreis aus Batterie und Verbraucher ein Widerstand eingebaut, dessen Widerstandswert im Verhältnis zum Widerstand des Verbrauchers sehr klein ist, so dass der an ihm auftretende Spannungsabfall beim maximalen Betriebsstrom des Verbrauchers gegenüber der Batteriespannung vernachlässigbar ist. Ein derartiger Messwiderstand heißt auch Shuntwiderstand. Als Maß für den Entlade- bzw. Ladestrom der Batterie wird die am Mess- oder Shuntwiderstand abfallende Spannung benutzt. Mit Hilfe eines Mikrocontrollers, werden die im System anfallenden Daten (Lade- und Entladeströme, Lade- und Entladezeiten sowie weitere für den Batteriezustand relevante Parameter) gespeichert und verarbeitet, um hieraus den Ladezustand der zu beobachtenden Batterie zu ermitteln. Um aus der am Mess- oder Shuntwiderstand abfallenden Spannung den der Batterie entnommenen bzw. in die Batterie eingespeisten Strom berechnen zu können, ist die genaue Kenntnis des Widerstandswerts des Mess- oder Shuntwiderstands notwendig.

In den bekannten Batteriemonitoren werden deshalb sogenannte Präzisionsshunts eingesetzt, deren Widerstandswerte eine sehr enge Toleranz aufweisen. Eine derartige Verwendung eines Präzisionsshunts ist zum Beispiel in der EP 1 030 185 A2 beschrieben. Diese Präzisionsshunts sind allerdings sehr teuer, so dass die Kosten für den Batteriemonitor oft die Kosten für eine Batterie übersteigen. Ziel ist es nun, die Batterie mit einem Batteriemonitor zu versehen, der während ihrer gesamten Lebensdauer an der Batterie verbleibt und beispielsweise mit ihr ein integrales Bauteil bildet. Dies ist wirtschaftlich nur dann sinnvoll, wenn die Kosten für den Batteriemonitor deutlich unter denen einer zu beobachtenden Batterie liegen.

In der DE 195 46 553 C1 wird ein Verfahren zum Prüfen der an eine Batterie angeschlossenen Verbraucher mittels einer Batteriestrommessung beschrieben. Hierbei dient der Innenwiderstand der Batterie als Messwiderstand, wobei der Widerstandswert des Innenwiderstands zu einem beliebig vorgebbaren Zeitpunkt gemessen werden kann. Nicht erwähnt ist eine Ermittlung des Ladezustands der Batterie.

Aus dem Labordatenblatt "Impulsbelastbarkeiten von Drahtwiderständen" des Unternehmens YAGEO EURORE GmbH vom November 2000 geht die Impulsbelastbarkeit von Widerständen je nach ihrer Dimensionierung hervor.

Mit der DE 199 18 529 A1 wird ein Verfahren zur Ermittlung des Ladezustands einer Batterie offenbart. Gemessen werden die Batteriespannung und der Batteriestrom. Daraus wird unter Zuhilfenahme zweier vorab ermittelter und hinterlegter Kennlinienzusammenhänge die der Batterie entnommene Ladungsmenge berechnet.

Anhand der Vorrichtung nach der DE 195 07 959 C1 kann eine Strommessung an einer Hauptstromzuleitung eines Kfz-Bordnetzes vorgenommen werden. Der Strom wird dabei an einem Messwiderstand ermittelt, der insbesondere auch als Abschnitt der Hauptstromleitung ausgebildet sein kann. Verwendet wird allerdings ein externes Prüfgerät, so dass die Messung nur während eines Werkstattaufenthalts und nicht zu einem beliebig vorgebbaren Zeitpunkt möglich ist. Außerdem kann der Ladezustand der Batterie mittels der beschriebenen Vorrichtung nicht ermittelt werden. Die Vorrichtung dient vielmehr zur Funktionsprüfung der Kfz-Elektrik.

Der Erfindung liegt nun die Aufgabe zu Grunde, ein Verfahren zum Ermitteln des Ladezustandes einer Batterie anzugeben, das gegenüber den im Stand der Technik bekannten Verfahren kostengünstiger durchgeführt werden kann. Außerdem liegt der Erfindung die Aufgabe zu Grunde, eine nach diesem Verfahren arbeitende Anordnung anzugeben.

Die genannten Aufgaben werden gemäß der Erfindung hinsichtlich des Verfahrens gelöst mit den Merkmalen des Patentanspruchs 1 und hinsichtlich der Anordnung mit den Merkmalen des Patentanspruchs 6.

Bei dem Verfahren gemäß Patentanspruch 1 wird der Ladezustand einer Batterie dadurch ermittelt, dass eine elektrische Größe erfasst wird, die an einem der Batterie in Serie geschalteten Messwiderstand auftritt, wobei dessen Widerstandswert zu einem beliebig vorgebbaren Zeitpunkt ermittelt wird und als Messwiderstand zumindest ein Teil der ohnehin vorhandenen elektrischen Anschlussmittel zum Anschluss der Batterie an einen Verbraucher vorgesehen wird. Unter einem beliebig vorgebbaren Zeitpunkt ist hierbei zu verstehen beispielsweise der Zeitpunkt vor der ersten Inbetriebnahme der Batterie oder ein periodisch wiederkehrender Zeitpunkt während der Einsatzdauer der Batterie oder ein Zeitpunkt, an dem der an die Batterie angeschlossene Verbraucher unter Volllast betrieben wird oder der Zeitpunkt, an dem sich die Batterie im Leerlauf befindet oder auch grundsätzlich ein extern frei wählbarer Zeitpunkt. Die elektrische Größe, die am Messwiderstand erfasst wird, ist eine Größe, die als Maß für den durch den Messwiderstand fließenden Strom benutzt werden kann. Bei einem ohmschen elektrischen Widerstand ist dies im Allgemeinen Fall die am Widerstand abfallende elektrische Spannung.

Durch die Ermittlung des Widerstandswertes des Messwiderstandes ist es möglich, anstelle eines teueren Präzisionsshunts einen vom Widerstandswert zunächst nicht genau bekannten (Teil)Widerstand der ohnehin vorhandenen elektrischen Anschlussmittel vorzusehen. Dadurch ergibt sich eine sehr kostengünstige Lösung. Als Messwiderstand kommt beispielsweise ein (Teil)Widerstand einer elektrischen Zuleitung, insbesondere der Masseleitung, in Frage. Dabei können die elektrischen Anschlussmittel insbesondere ein Kabel umfassen. Weitere Komponenten wie beispielsweise mindestens ein Befestigungselement, insbesondere ein Kabelschuh oder eine Klemme, und mindestens ein Sicherungselement, insbesondere eine Schmelzsicherung, können ebenfalls als Bestandteile der elektrischen Anschlussmittel vorgesehen sein. Der Widerstandswert des Messwiderstands, der zur Ermittlung des Ladezustands der Batterie benötigt wird, wird dann zu einem beliebig vorgebbaren Zeitpunkt in gewünschter Genauigkeit ermittelt. Für den Messwiderstand, dessen Widerstandswert zunächst nicht genau bekannt ist, fallen praktisch keine zusätzlichen Kosten an. Die Kosten für zusätzliche Bauteile, die zur Ermittlung des Widerstandswertes des Messwiderstands in der gewünschten Genauigkeit gegebenenfalls notwendig sind, können dann deutlich unter den Kosten für einen Präzisionsshunt liegen.

In einer bevorzugten Ausgestaltung der Erfindung werden der Serienschaltung aus Batterie und Messwiderstand ein Referenzwiderstand parallel und vorzugsweise kurzzeitig zugeschaltet und die am Messwiderstand und am Referenzwiderstand jeweils auftretende elektrische Größe ausgewertet. Der Widerstandswert des Messwiderstands kann dadurch mit einer Genauigkeit bestimmt werden, die nur noch von der Genauigkeit der Kenntnis des Widerstandswertes des Referenzwiderstands abhängig ist. Da es sich bei diesem Referenzwiderstand um einen handelsüblichen Standard-Widerstand kleiner Leistung handeln kann, ist dieser trotz relativ hoher Genauigkeit als Massenprodukt sehr kostengünstig verfügbar. Durch die Verwendung eines Referenzwiderstands von ausreichender Genauigkeit, ist es möglich, den Widerstandswert des Messwiderstands mit einer Genauigkeit zu messen, die dem Toleranzbereich eines Präzisionsshunts entspricht.

Der Betrieb des Verbrauchers wird wegen der Parallelschaltung von Referenzwiderstand und Schaltelement zu ihm und des kleinen, der Batterie zusätzlich und kurzzeitig entnommenen Stroms nicht beeinträchtigt. Durch die Möglichkeit, zu jedem beliebigen Zeitpunkt den Widerstandswert des Messwiderstands in gewünschter Genauigkeit ermitteln zu können, können Effekte wie z.B. Temperaturdrift oder Veränderung des Widerstandswertes des Messwiderstands durch Alterung erfasst werden.

In einer weiteren vorteilhaften Ausgestaltung der Erfindung erfolgt die Zuschaltung des Referenzwiderstandes parallel zum Verbraucher über ein steuerbares, vorzugsweise elektronisches Schaltelement, insbesondere über einen Schalttransistor. Vorzugsweise wird hierbei der Spannungsabfall am Referenzwiderstand kurz vor und kurz nach dem Zeitpunkt des Umschaltens des Schaltelements ausgewertet. Bedingung ist dabei, dass der Strom durch den Verbraucher zu beiden Zeitpunkten als gleich angenommen werden darf. Die Verwendung eines elektronischen Schaltelementes bringt somit weitere Vorteile in Bezug auf die Schnelligkeit des Durchschaltens und somit in Bezug auf die Einhaltung der zur Berechnung notwendigen Bedingung der Konstanz des Verbraucherstroms während der Einschaltzeit.

Vorzugsweise wird der Referenzwiderstand nur kurzzeitig zugeschaltet. Außerdem kann er im Rahmen seiner Spezifikation während der kurzen Zuschalt-Zeitdauer insbesondere auch mit mehr als seiner Nennleistung betrieben werden. Dadurch kann in einer vorteilhaften Ausgestaltung der Erfindung ein leistungsschwächerer Referenzwiderstand Verwendung finden, was weiter zur Senkung der Kosten im Gesamtsystem ohne Verlust an Genauigkeit der Messungen beiträgt.

In einer weiteren vorteilhaften Ausgestaltung des Verfahrens wird zusätzlich die Temperatur der Batterie ermittelt und zur Berechnung des Ladezustand der Batterie verwendet, was zu einer weiteren Präzisierung des Ergebnisses des Verfahrens beiträgt.

Weitere vorteilhafte Ausgestaltungen der Erfindung sind in den den unabhängigen Patentansprüchen jeweils zugeordneten Unteransprüchen angegeben.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Aspekte sind schematisiert dargestellt. Im Einzelnen zeigen die:

Fig. 1    eine Anordnung zur Ermittlung des Ladezustands einer Batterie in einem elektrischen Prinzipschaltbild,

Fig. 2    den qualitativen Verlauf des Stromes durch den Referenzwiderstand beim Schaltvorgang des Schaltelements,

Fig. 3    eine weitere Anordnung zur Ermittlung des Ladezustands einer Batterie in einem elektrischen Prinzipschaltbild.

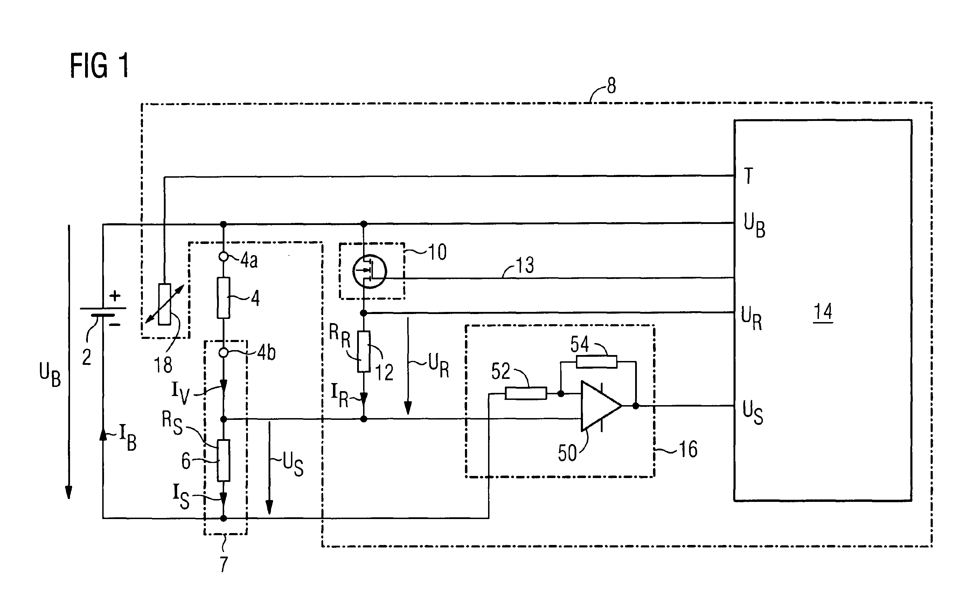

Einander entsprechende Teile sind in den Figuren 1 bis 3 mit denselben Bezugszeichen versehen.

Gemäß Fig. 1 ist in den Strompfad zwischen einer Batterie 2, im Ausführungsbeispiel ein Bleiakkumulator mit einer Nennspannung bis zu 42V, und einem von dieser versorgten Verbraucher 4, ein Shuntwiderstand 6 geschaltet.

An Batterie 2, Verbraucher 4 und Shuntwiderstand 6 ist eine Messanordnung 8 angeschlossen, die zur Ermittlung des Widerstandswerts $R_S$ des Shuntwiderstands 6 und zur Ermittlung des Ladezustands der Batterie 2 dient. Messanordnung 8 und Shuntwiderstand 6 sind vorzugsweise dauerhaft, d.h. während der gesamten Lebensdauer der Batterie 2, an diese angeschlossen.

In der hier gezeigten bevorzugten Ausgestaltung wird der Verbraucher 4 nach Bedarf an die Klemmen 4a und 4b angeschlossen. Um die Batterie 2 zu laden, wird an die Klemmen 4a und 4b strenggenommen kein Verbraucher 4 sondern eine Ladevorrichtung angeschlossen. Der Ausdruck "Verbraucher 4" soll deshalb im Folgenden beide Fälle einschließen.

In einer bevorzugten konkreten Ausführungsform sind für den Benutzer der Anordnung nur die Klemmen 4a und 4b der Anordnung zugänglich. Mit anderen Worten: Der Shuntwiderstand 6 ist in die Batterie 2 integriert, so dass dieser beispielsweise gemeinsam mit der Batterieklemme 4a eine bauliche Einheit 7 bildet. Beispielsweise kann der Shuntwiderstand 6 im Bereich einer Polnische der Batterie 2 angeordnet oder integriert sein. Günstig ist es, wenn die zwar dauerhaft vorgesehene Verbindung dennoch von außen zugänglich und auch lösbar ausgebildet ist. Alle Lade- und Entladeströme der Batterie 2 verlaufen auch über den Shuntwiderstand 6 und können somit lückenlos erfasst werden. Alternativ hierzu kann der Shuntwiderstand 6 auch in die Masseleitung integriert oder als Teil derselben ausgebildet sein. Zusätzlich kann auch die Messanordnung 8 fest an die Batterie 2 angeschlossen sein, so dass diese mit dem Shuntwiderstand 6 einen integralen Bestandteil der Batterie 2 bildet. Auch die Messanordnung 8 kann dabei im Bereich der Polklemme, insbesondere in der Polnische und vorzugsweise ebenfalls von außen zugänglich und lösbar, angeordnet sein.

Der Widerstandswert $R_S$ des Shuntwiderstands 6 (Nennwert + Toleranz) ist so gewählt, dass beim maximal zulässigen Verbraucherstrom $I_{V,max}$ durch den Verbraucher 4, maximal zulässigen Referenzstrom $I_{R,\,max}$ durch den Referenzwiderstand 12 und der Nennbatteriespannung $U_{B,\,nenn}$ gilt:

$$U_{S,max} = R_S * (I_{V,max} + I_{R,max}) \ll U_{B,nenn}$$

Im Ausführungsbeispiel beträgt der Widerstandswert $R_S$ des Shuntwiderstands 6 für eine Nennbatteriespannung $U_{B,\,nenn}$ zwischen 12V und 42V etwa $100\mu\Omega$. Der Shuntwiderstand 6 kann eine hohe Toleranz bis zu 20 % aufweisen und ist beispielsweise ein kostengünstiger Manganinshunt aus Press- und Stanzteilen.

Zur Bestimmung des tatsächlichen Widerstandswerts $R_S$ umfasst die Messanordnung 8 einen Referenzwiderstand 12, der mit Hilfe eines steuerbaren elektronischen Schaltelements 10, im Ausführungsbeispiel ein Schalttransistor, dem Verbraucher 4 und damit der Serienschaltung aus Shuntwiderstand 6 und Batterie 2 parallel geschaltet wird. Das Schaltelement 10 wird über eine Steuerleitung 13 von einer Steuer- und Recheneinrichtung, im Ausführungsbeispiel ein Mikrocontroller 14, angesteuert.

Im Mikrocontroller 14 werden neben der Batteriespannung $U_B$ eine am Referenzwiderstand 12 und eine am Shuntwiderstand 6 jeweils auftretende elektrische Größe, im Ausführungsbeispiel jeweils der Spannungsabfall $U_R$ (Referenzspannung) bzw. $U_S$ (Shuntspannung), erfasst und zur Ermittlung des Ladezustands der Batterie 2 weiterverarbeitet. Die hierzu erforderliche A/D-Wandlung kann durch externe oder durch in den Mikrocontroller 14 integrierte A/D-Wandler erfolgen. Außerdem ist auch eine Einbindung in eine Bus-Architektur möglich.

Im Ausführungsbeispiel ist zur Verstärkung des am Shuntwiderstand 6 auftretenden kleinen Spannungsabfalls $U_S$ ein Verstärker 16 mit niedriger Offsetdrift vorgesehen. Gemäß Beispiel nach Fig. 1 umfasst dieser einen Operationsverstärker 50 mit einem durch Widerstände 52 und 54 eingestellten Verstärkungsverhältnis.

Befindet sich das Schaltelement 10 in geöffneter Position ("AUS"), fließt durch den Referenzwiderstand 12 kein Referenzstrom $I_R$ und es gilt $I_{R,aus} = 0$ und dementsprechend für den Spannungsabfall am Referenzwiderstand 12 , also für die Referenzspannung $U_R$: $U_{R,aus} = 0$. Für den Shuntstrom $I_S$ durch den Shuntwiderstand 6 gilt dann:

$$I_{S,aus} = U_{S,aus} / R_S$$

Der Shuntstrom $I_{S,\,aus}$ ist außerdem gleich dem durch den Verbraucher 4 fließenden Verbraucherstrom $I_{V,\,aus}$ ($I_{S,\,aus} = I_{V,\,aus}$).

Ist das Schaltelement 10 leitend ("EIN"), so fließt durch den Referenzwiderstand 12 mit dem Widerstandswert $R_R$ der Referenzstrom $I_{R,ein}$ und es fällt an ihm die Referenzspannung $U_{R,ein}$ ab. Dann gilt:

$$I_{S,ein} = U_{S,ein} / R_S = I_{V,ein} + I_{R,ein} = I_{V,ein} + U_{R,ein} / R_R$$

Der Spannungsabfall(Referenzspannung) $U_{R,ein}$ am Referenzwiderstand 12 kann mit hoher Genauigkeit bestimmt werden. Die Genauigkeit, mit welcher der Referenzstrom $I_R$ bestimmt werden kann, hängt dann nur noch von der Toleranz des verwendeten Referenzwiderstands 12 ab. Im Ausführungsbeispiel wird ein Referenzwiderstand 12 verwendet. Dessen Toleranz kleiner als 0,5% ist und dessen Widerstandswert zwischen 0,2 $\Omega$ und 50 $\Omega$ beträgt.

Der vom Mikrocontroller 14 erfasste Spannungsabfall $U_S$ am Shuntwiderstand 6 (Shuntspannung) ist über die Beziehung $I_S = U_S / R_S$ ein Maß für den von der Batterie 2 abgegebenen oder in die Batterie 2 eingespeisten Entlade- bzw. Ladestrom $I_B$. Der Shuntstrom $I_S$ und der Entlade- bzw. Ladestrom $I_B$ sind praktisch gleich groß, da über die Leitungen zum Spannungsabgriff am Shuntwiderstand 6, welche zum Verstärker 16 führen, keine nennenswerten Ströme fließen. Aus dem Strom $I_S$, genauer einer der Shuntspannung $U_S$ proportionalen Größe, wird im Mikrocontroller 14 zumindest approximativ ein Zeitintegral errechnet, aus dem dann der aktuelle Ladezustand der Batterie 2 abgeleitet wird. Dieser aktuelle Ladezustand hängt außer von batteriespezifischen Parametern, beispielsweise der Nennkapazität, auch noch von der jeweils beim Entladen oder Laden herrschenden Batterietemperatur T ab. Zur Erfassung dieser Batterietemperatur T ist ein Temperaturfühler 18 vorgesehen, der ebenfalls am Mikrocontroller 14 angeschlossen ist.

Zur Ermittlung einer genauen Ladungsbilanz der Batterie 2 ist die entsprechend genaue Kenntnis des Widerstandswertes $R_S$ des Shuntwiderstands 6 erforderlich.

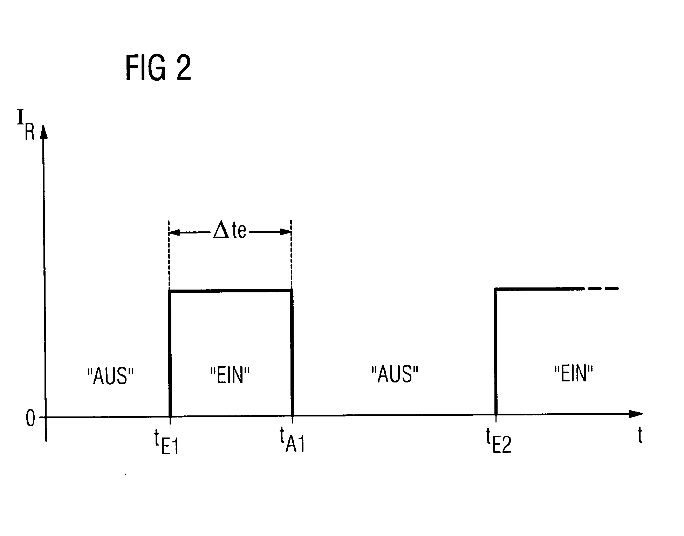

Die Berechnung des Widerstandswertes $R_S$ wird mit Hilfe von Fig. 2 für den Einschaltvorgang erläutert. Dort ist der qualitative Verlauf des durch den Referenzwiderstand 12 fließenden Referenzstroms $I_R$ angegeben, wenn das Schaltelement 10 zum Zeitpunkt $t_{E1}$ von der Position "AUS" in die Position "EIN" wechselt. Die Messung der Referenzspannung $U_{R,ein}$ und der Shuntspannung $U_{S,ein}$ erfolgt unmittelbar nach dem Durchschalten des Schaltelements 10 ("AUS"->"EIN"), so dass der Verbraucherstrom $I_V$ als konstant angenommen werden darf, dass also gilt:

$$I_{V,ein} = I_{V,aus}$$

$I_{V,aus}$ bzw. $I_{V,ein}$ sind die Werte des Verbraucherstromes $I_V$ durch den Verbraucher 4 unmittelbar vor dem Beginn bzw. nach dem Ende des Durchschaltvorgangs "AUS" -> "EIN" des Schaltelements 10. Die Kontrolle der Einhaltung dieser Bedingung (beispielsweise sprunghafte Veränderung von $I_V$ bei Schaltvorgängen im Verbraucher 4 zum gleichen Zeitpunkt des Durchschaltens des Schaltelements 10) wird in vorteilhafter Weise vom Mikrocontroller 14 durchgeführt.

Mit den oben erklärten Größen gilt sodann:

$$U_{S,aus} / R_S = I_{V,aus}$$

und

$$U_{S,ein} = R_S ( I_{V,ein} + U_{R,ein} / R_R )$$

Mit $I_{V,ein} = I_{V,aus}$ folgt:

$$U_{S,ein} = R_S ( I_{V,aus} + U_{R,ein} / R_R ) = R_S (U_{S,aus} / R_S + U_{R,ein} / R_R) =$$

$$U_{S,aus} + (U_{R,ein} R_S / R_R) \, ,$$

und somit

$$R_S = R_R (U_{S,ein} - U_{S,aus}) / U_{R,ein}$$

Die Genauigkeit, mit der der Widerstandswert $R_S$ bestimmt wird, hängt von der oben gewählten Toleranz bei der Wahl des Referenzwiderstandes 12 ab.

Das Schaltelement 10 schaltet zum Zeitpunkt $t_{A1}$ von der Position "EIN" in die Position "AUS". Die gesamte Dauer des "EIN" - Zustands des Schaltelements 10 $\Delta t_e = t_{A1} - t_{E1}$ (im Ausführungsbeispiel < 0,1s) ist so dimensioniert, dass der Referenzwiderstand 12 im Rahmen seiner Spezifikation während dieser Zeitspanne mit mehr als seiner Nennleistung belastet werden darf. Hierdurch werden der Referenzstrom $I_R$ und somit die Spannung $U_{R,ein}$ im durchgeschalteten Zustand "EIN" des Schaltelements 10 und die Spannungsdifferenz $U_{S,ein} - U_{S,aus}$ größer, was zu genaueren Ergebnissen bei der Berechnung von $R_S$ führt.

Der Widerstandswert $R_S$ kann z.B. zu zeitlich periodisch aufeinanderfolgenden Zeitpunkten, zum Zeitpunkt eines Vollastbetriebs der Batterie 2, zum Zeitpunkt eines Batterieleerlaufs oder kurz vor dem Zuschalten eines Verbrauchers 4 erfolgen. Die zu den jeweiligen Zeitpunkten ermittelten Widerstandswerte $R_S$ können nun z.B. gemittelt werden und für die Berechnung der Ladungsbilanz im Mikrocontroller 14 der Mittelwert verwendet werden oder es können für verschiedene Betriebszustände verschiedene Widerstandswerte $R_S$ in die Berechnungen des Mikrocontrollers 14 eingehen.

In Stillstandszeiten der Batterie 2 (kein Entlade- oder Ladestrom) kann der Ladezustand der Batterie 2 im Mikrocontroller 14 auch mit hinreichender Genauigkeit allein aus den Größen Batteriespannung $U_B$ und Batterietemperatur T, d. h. ohne die Zuschaltung des Referenzwiderstandes 12, ermittelt werden.

Zur Ermittlung des Wertes des Shuntwiderstands kann der Einschalt- ("AUS" -> "EIN") oder der Ausschaltvorgang ("EIN" -> "AUS") des Schaltelements 10 benutzt werden.

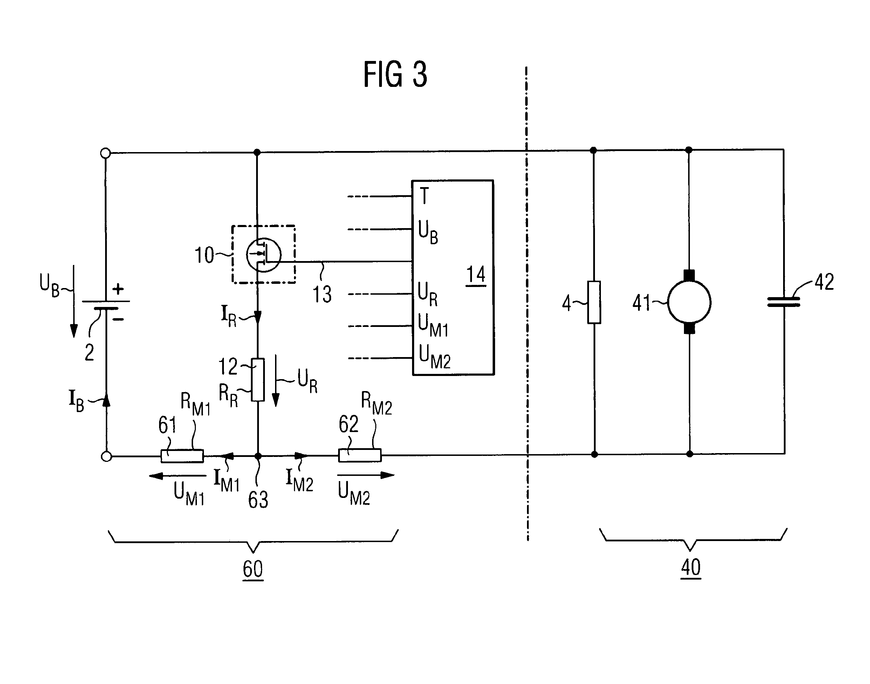

Im Ausführungsbeispiel nach Fig. 3 wird eine weitere Anordnung zur Bestimmung des Lagezustands der Batterie 2 gezeigt. Die Batterie 2 dient zur Versorgung eines Kfz-Bordnetzes 40, das neben dem nicht näher spezifizierten mindestens einen Verbraucher 4 auch einen Generator 41 und gegebenenfalls ein weiteres Speicherelement 42 beinhaltet. Das weitere Speicherelement 42 kann dabei auch durchaus eine von einer Batterie verschiedene Ausgestaltung, beispielsweise in Form einer Kapazität oder einer Induktivität, annehmen.

Anstelle des Shuntwiderstands 6 der in Fig. 1 gezeigten Anordnung ist beim Beispiel von Fig. 3 ein Teilabschnitt einer ohnehin vorhandenen Massezuleitung 60 der Batterie 2 vorgesehen. Dadurch ergibt sich ein weiterer Kostenvorteil, da das zusätzliche Bauelement in Form des Shuntwiderstands 6 entfallen kann. Als Messwiderstand dient im Ausführungsbeispiel von Fig. 3 stattdessen ein (Teil)Messwiderstand 61, der durch den Widerstandswert $R_{M1}$ eines Abschnitts der Massezuleitung 60 gebildet ist. Der Abschnitt der Massezuleitung 60 wird hier mittels eines Abgriffs 63 gebildet. Der Abgriff 63 dient auch zum elektrischen Anschluss des Referenzwiderstands 12 an die Masseleitung 60 und damit auch an den Messwiderstand 61. Der Widerstandswert $R_{M1}$ des Messwiderstands 61 lässt sich im Wesentlichen analog zu dem im Zusammenhang mit den Figuren 1 und 2 beschriebenen Verfahren ermitteln. Aus Gründen der besseren Übersichtlichkeit ist in Fig. 3 die Messanordnung 8 nicht komplett mit eingetragen worden. Sie ist jedoch in ähnlicher Weise wie im Beispiel von Fig. 1 vorhanden. Stellvertretend ist in Fig. 3 der Mikrocontroller 14 enthalten.

Zusätzlich zur Erfassung der am Messwiderstand 61 abfallenden Messspannung $U_{M1}$ ist im Ausführungsbeispiel von Fig. 3 auch die Erfassung einer weiteren Messspannung $U_{M2}$ vorgesehen. Diese weitere Messspannung $U_{M2}$ fällt an einem einen zweiten (Teil)Messwiderstand 62 bildenden Abschnitt der Massezuleitung 60 ab. Dieser zweite Messwiderstand 62 hat einen Widerstandswert $R_{M2}$. Die Erfassung der zweiten Messspannung $U_{M2}$ erfolgt analog zu der der ersten Messspannung $U_{M1}$ mittels des Mikrocontrollers 14 (siehe zusätzlichen Spannungsmesseingang in der Darstellung von Fig. 3). Die Berücksichtigung dieser zweiten Messspannung $U_{M2}$ ist jedoch nur optional. Sie dient in erster Linie einer Verbesserung der Messqualität.

So kann es nämlich gerade bei einem Bordnetz 40, das Energiequellen und/oder Energiesenken mit kapazitiven und/oder induktiven Eigenschaften, beispielsweise in Gestalt des Speicherelements 42, besitzt, dazu kommen, dass der Referenzstrom $I_R$ auch eine kleinen Stromanteil umfasst, der nicht aus der zu überwachenden (Bordnetz-) Batterie 2 stammt. Der Referenzstrom $I_R$ setzt sich dann aus den beiden Messströmen $I_{M1}$ und $I_{M2}$ zusammen. Mittels der zusätzlichen Erfassung der Messspannung $U_{M2}$ kann der Anteil $I_{M2}$ im Referenzstrom $I_R$ in der Auswertung berücksichtigt werden.

Außerdem kann der als Teilabschnitt der Masseleitung 60 ausgebildete erste Messwiderstand 61 eine gewisse Temperaturabhängigkeit aufweisen, die von dem verwendeten Material (beispielsweise Kupfer oder Aluminium) herrührt. Da der zweite Messwiderstand 62 aus demselben Material besteht, kann auch der Temperatureffekt anhand der zusätzlich erfassten zweiten Messspannung $U_{M2}$ kompensiert werden. Hierzu werden der Referenzstrom $I_R$ und die Widerstandswerte $R_{M1}$ and $R_{M2}$ bei einer bestimmten Temperatur, beispielsweise bei der Nenn-Betriebstemperatur, vorab ermittelt und in der Messanordnung 8 hinterlegt. Die Widerstandswerte $R_{M1}$ und $R_{M2}$ der beiden Messwiderstände 61 bzw. 62 lassen sich dann für die jeweils aktuelle Betriebstemperatur auf einfache Weise über einen multiplikativen Kompensationsfaktor k aus den bei der Referenztemperatur ermittelten Widerstandswerten bestimmen. Der Kompensationsfaktor k kann durch eine Quotientenbildung zwischen dem bei der Referenztemperatur ermittelten Wert des Referenzstroms $I_R$ und dem aktuell ermittelten Wert des Referenzstroms $I_R$ berechnet werden. Die übrigen Auswertungen erfolgen wie im Zusammenhang mit den Figuren 1 und 2 bereits ausführlich beschrieben.

Besonders vorteilhaft ist es, wenn der Abgriff 63 als sogenannter Mittenabgriff ausgebildet ist, d.h. wenn sich der Abgriff 63 im Wesentlichen in der Mitte der Massezuleitung 60 befindet. Dann ergibt sich eine besonders hohe Messqualität. Unter Berücksichtigung der Widerstandswerte der gegebenenfalls zum Anschluss der Messwiderstände 61 und 62 verwendeten Klemmen kann aber auch eine andere geometrisch nicht symmetrische Aufteilung der Massezuleitung 60 vorteilhaft sein.

Im Falle der zusätzlichen Erfassung der Messspannung $U_{M2}$ ist außerdem auch eine Auswertung möglich, die sich auf die Spannungsänderungen an den Messwiderständen 61 und 62 beim Zuschalten des Referenzwider-

EP 1 378 757 A2

stands 12 stützt. Die Spannungsänderungen werden hierbei als Differenz der vor und nach dem Zuschalten an den jeweiligen Messwiderständen 61 und 62 abfallenden Messspannungen $U_{M1}$ bzw. $U_{M2}$ ermittelt und für die weitere Auswertung, insbesondere zur genauen Ermittlung des Widerstandswerts $R_{M1}$ oder des für die Bestimmung des Ladezustands eigentlich interessierenden Messstroms $I_{M1}$ (= $I_B$), verwendet.

**Patentansprüche**

1.  Verfahren zur Ermittlung des Ladezustands einer Batterie (2) durch Erfassen einer an einem in Serie zur Batterie (2) geschalteten Messwiderstand (6, 61) auftretenden elektrischen Größe, bei dem der Widerstandswert des Messwiderstands (6, 61) zu einem beliebig vorgebbaren Zeitpunkt gemessen wird und als Messwiderstand (6, 61) zumindest ein Teil der ohnehin vorhandenen elektrischen Anschlussmittel (60) zum Anschluss der Batterie (2) an einen Verbraucher (4) vorgesehen wird.

2.  Verfahren nach Anspruch 1, bei dem der Serienschaltung aus Batterie (2) und Messwiderstand (6, 61) zum Messen des Widerstandswertes des Messwiderstand (6, 61) ein Referenzwiderstand (12) parallel zugeschaltet und die am Messwiderstand (6, 61) und am Referenzwiderstand (12) jeweils auftretende elektrische Größe ausgewertet werden.

3.  Verfahren nach Anspruch 2, bei dem der Referenzwiderstand (12) kurzzeitig zugeschaltet und insbesondere mit mehr als seiner Nennleistung belastet wird.

4.  Verfahren nach einem der vorhergehenden Ansprüche, bei dem die elektrische Größe am Referenzwiderstand (12) bzw. am Messwiderstand (6, 61) die an diesen jeweils abfallende elektrische Spannung ($U_R$ bzw. $U_S$, $U_{M1}$) ist.

5.  Verfahren nach einem der vorhergehenden Ansprüche, bei dem die Temperatur (T) der Batterie (2) gemessen und bei Ermittlung des Ladezustands der Batterie (2) berücksichtigt wird.

6.  Anordnung zur Ermittlung des Ladezustands einer Batterie (2) mit einem in Serie zur Batterie (2) geschalteten Messwiderstand (6, 61) und mit einer Messanordnung (8) zum Erfassen einer am Messwiderstand (6, 61) auftretenden elektrischen Größe und zur Messung des Widerstandswertes des Messwiderstands (6, 61) zu einem beliebig vorgebbaren Zeitpunkt, wobei der Messwiderstand (6, 61) zumindest ein Teil der ohnehin vorhandenen Anschlussmittel (60) zum Anschluss der Batterie (2) an einen Verbraucher (4) ist.

7.  Anordnung nach Anspruch 6, bei der die Messanordnung (8) zur Ermittlung des Widerstandswerts des Messwiderstands (6, 61) einen der Serienschaltung aus Batterie (2) und Messwiderstand (6, 61) parallel zuschaltbaren Referenzwiderstand (12) umfasst und die am Messwiderstand (6, 61) und am Referenzwiderstand (12) jeweils auftretende elektrische Größe auswertet.

8.  Anordnung nach Anspruch 7, bei der die elektrische Größe am Referenzwiderstand (12) bzw. am Messwiderstand (6, 61) die an diesen jeweils abfallende elektrische Spannung ($U_R$ bzw. $U_S$, $U_{M1}$) ist.

9.  Anordnung nach Anspruch 8, bei dem zum Zuschalten des Referenzwiderstandes (12) ein in Serie zu ihm geschaltetes steuerbares Schaltelement (10) vorgesehen ist.

10. Anordnung nach einem der Ansprüche 6 bis 9 mit einem Verstärker (16) zum Verstärken der am Messwiderstand (6, 61) auftretenden elektrischen Größe.

11. Anordnung nach einem der Ansprüche 6 bis 10, bei der der Messwiderstand (6) Teil der Batterie (2) ist.

12. Anordnung nach einem der Ansprüche 6 bis 11, bei der der Messwiderstand (6, 61) in die Masseleitung der Batterie (2) integriert ist.

13. Anordnung nach einem der Ansprüche 6 bis 12, mit einem Temperaturfühler (18) zur Messung der Temperatur der Batterie (2).

14. Anordnung nach einem der Ansprüche 6 bis 13, bei der der Messwiderstand (61) als zumindest ein Teil einer Zuleitung, insbesondere der Masseleitung (60), der Batterie (2) ausgebildet ist.

7

**15.** Anordnung nach Anspruch 14, bei der der Messwiderstand (61) durch eine Zweiteilung der Zuleitung mittels eines Abgriffs (63), an den der Referenzwiderstand (12) elektrisch angeschlossen ist, gebildet ist.

**16.** Anordnung nach Anspruch 15, bei der der Abgriff (63) als Mittenabgriff ausgebildet ist.

**17.** Anordnung nach einem der Ansprüche 6 bis 16, bei der der Messwiderstand (61) durch den Widerstandswert oder den Teilwiderstandswert zumindest eines der Elemente aus der Gruppe von einem Kabel, einem Befestigungselement, insbesondere einem Kabelschuh oder einer Klemme, und einem Sicherungselement, insbesondere einer Schmelzsicherung, gebildet ist.

# FIG 1

FIG 2

"AUS"    "EIN"    "AUS"    "EIN"

FIG 3